## Europäisches Patentamt

## European Patent Office

## Office européen des brevets

(19)

(11) Veröffentlichungsnummer: **0 067 301**
**B1**

(12) **EUROPÄISCHE PATENTSCHRIFT**

(45) Veröffentlichungstag der Patentschrift:
26.08.87

(51) Int. Cl.⁴: **G 06 F 11/10**

(21) Anmeldenummer: **82103932.8**

(22) Anmeldetag: **06.05.82**

(54) **Einrichtung zur Erzeugung von Prüfbits zur Sicherung eines Datenwortes.**

(30) Priorität: **05.06.81 DE 3122381**

(43) Veröffentlichungstag der Anmeldung:
**22.12.82 Patentblatt 82/51**

(45) Bekanntmachung des Hinweises auf die Patenterteilung:
**26.08.87 Patentblatt 87/35**

(84) Benannte Vertragsstaaten:
**DE FR GB IT**

(56) Entgegenhaltungen:
US - A - 3 218 612
US - A - 3 745 526
US - A - 3 825 893
US - A - 4 355 391

COMPUTER DESIGN, Band 19, Nr. 8, August 1980, Seiten 101-108, Concord, USA. R. SWANSON: "Matrix technique to direct error code implementation"
IBM TECHNICAL DISCLOSURE BULLETIN, Band 23, Nr. 7B, Dezember 1980, Seiten 3272-3273, New York, USA: R. A. FORSBERG et al.: "Error detection for memory with partially good chips"
IBM TECHNICAL DISCLOSURE BULLETIN, Band 22, Nr. 6, November 1979, Seiten 2360-2364, New York, USA: C. L. CHEN et al.: "Parallel-serial implementation of error correcting code system"
ELECTRONICS, Band 51, Nr. 23, November 1978, Seiten 130-133, New York, USA. R. SCHÜRBA: "Chip cuts parts count in error correction networks"
PATENTS ABSTRACTS OF JAPAN, Band 6, Nr. 209(P-150)(1087), 21. Oktober 1982

(73) Patentinhaber: **IBM DEUTSCHLAND GMBH, Pascalstrasse 100, D-7000 Stuttgart 80 (DE)**

(84) Benannte Vertragsstaaten: **DE**

(73) Patentinhaber: **International Business Machines Corporation, Old Orchard Road, Armonk, N.Y. 10504 (US)**

(84) Benannte Vertragsstaaten: **FR GB IT**

(72) Erfinder: **Götze, Volkmar, Dipl.-Ing., Malteserstrasse 69, D-7031 Grafenau 2 (DE)**
Erfinder: **Potz, Günther, Dipl.-Ing., Amselweg 21, D-7032 Sindelfingen (DE)**

(74) Vertreter: **Lewit, Leonard, Dipl.-Ing., IBM Deutschland GmbH Schönaicher Strasse 220, D-7030 Böblingen (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Prüfbits finden z.B. zur Fehlersicherung von Datenworten in Datenverarbeitungsanlagen Verwendung. Dabei werden beim Einschreiben des Datenwortes in den Speicher der Anlage nach einer bestimmten Kodevorschrift Prüfbits erzeugt und zusammen mit dem Datenwort im Speicher abgespeichert. Beim Auslesen des Datenwortes werden nach derselben Kodevorschrift nochmals Prüfbits zu dem ausgelesenen Datenwort erzeugt und mit den ursprünglich abgesicherten Prüfbits verglichen. Aus dem Vergleich einander entsprechender Prüfbits werden die sogenannten Syndrombits erhalten. Sind alle Syndrombits 0, so entspricht das gelesene Datenwort dem eingeschriebenen. Ist eines oder sind mehrere Syndrombits ungleich 0, so liegt ein Fehler vor und je nach dem verwendeten Kode kann durch Dekodierung des Syndrombitmusters auf einen oder mehrere Fehler geschlossen und eine begrenzte Anzahl von Fehlern korrigiert werden. Einrichtungen zur Fehlererkennung und Fehlerkorrektur der genannten Art sind z.B. in den US-Patentschriften 3 623 155, 3 648 239 und 3 755 779 beschrieben und werden vielfach als «ECC»-Einrichtungen bezeichnet.

Je nachdem, ob die Datenbits seriell oder parallel ankommen, wird auch die Prüfbiterzeugung seriell oder parallel erfolgen. Eine serielle Prüfbiterzeugung ergibt sich zumeist im Zusammenhang mit seriellen Aufzeichnungsgeräten, wie z.B. Magnetbandspeicher. Je nach Art der Ableseeinrichtung kann dabei die Prüfbiterzeugung auch byteseriell erfolgen (US-PS 3 851 306 und 3 868 632).

In der Patentschrift US-A-3 825 893 ist eine modulare Einrichtung zur Erzeugung von Prüfbits beschrieben, in der für jedes Byte des zu sichernden Datenwortes ein Standardmodul verwendet wird. Dies wird in der bekannten Einrichtung dadurch ermöglicht, dass ein spezieller Hamming Kode verwendet wird, der sich aus der zyklischen Permutation der sich auf Datenbyte beziehenden Zeilenteile der H-Matrix ergibt. Bei einem solchen Kode kann durch spezielle Verdrahtung der Moduln untereinander das zu einer Zeile der H-Matrix gehörende Prüfbit byteweise erzeugt und modulo 2 aufaddiert werden.

In der Patentschrift US-A-3 745 526 ist eine Fehlerkorrektureinrichtung beschrieben, in der die Kodematrix in Untermatrizen aufgeteilt ist. Das zu sichernde Datenwort ist ebenfalls in geeignete Unterabschnitte unterteilt und jeweils ein Abschnitt des Datenwortes wird mit Hilfe einer Untermatrix verarbeitet. Das zu erzeugende Prüfbyte wird durch eine modulo 2 Addition der jeweils zu einem Wortabschnitt erzeugten Prüfbits erhalten.

In der Patentschrift US-A-3 218 612 wird eine Fehlerkorrektureinrichtung beschrieben, welche auch die einzelnen Bytes eines zu übertragenden Datenwortes sichert. Vor der Übertragung werden zu jedem Datenbyte Prüfbits erzeugt, welche eine Einzelfehlerkorrektur in diesem Byte gestatten. Das zum gesamten Datenwort erzeugte Prüfbyte ergibt sich aus den von den einzelnen Bytes abhängigen Prüfbits.

Die bekannten Einrichtungen haben alle den Nachteil, dass sie jeweils für eine spezielle Verwendung ausgelegt sind. Eine einmal entworfene ECC-Einrichtung ist nur für einen bestimmten Kode brauchbar und ist auch nur entweder für serielle oder parallele Arbeitsweise geeignet. Auch hinsichtlich der Anzahl Bytes im Datenwort sowie der Anzahl Bits pro Byte sind die bekannten Einrichtungen nur für jeweils eine bestimmte Anzahl ausgerichtet. Bei Implementierung der ECC-Einrichtung auf einem Halbleiterchip kann also eine bestehende ECC-Einrichtung an geänderte Umstände nicht angepasst werden. Vielmehr muss ein neues ECC-Chip entwickelt werden, was für viele Verwendungszwecke eine zu grosse Zeit in Anspruch nimmt.

Der vorliegenden Erfindung liegt daher die Aufgabe zugrunde, eine modulare Einrichtung zur Erzeugung von Prüfbits derart anzugeben, dass eine weitgehende Kode unabhängige Verwendbarkeit ermöglicht wird.

Die Lösung dieser Aufgabe ist in den Patentansprüchen gekennzeichnet. Durch die erfindungsgemässe byte-serielle Art Prüfbits zu erzeugen, wird ein Aufbau der ECC-Einrichtung ermöglicht, der in hohem Masse universell verwendbar ist. Die Erzeugung eines Paritätsbits zu jeweils einem Byte ist nicht kodeabhängig, so dass dafür Standardeinheiten vorgesehen werden können. Dasselbe gilt für die byte-serielle Zuführung der Datenbytes zu den Paritätsbits-Erzeugungseinrichtungen. Schliesslich ist auch die Paritätsbits-Akkumulierungseinrichtung nicht vom Kode abhängig, so dass einzig und allein die Auswahl der zur Erzeugung eines Byte-Paritätsbits nötigen Datenbits kodeabhängig ist. Diese Auswahl kann jedoch in vorteilhafter Weise dadurch erfolgen, dass Torschaltungen vorgesehen werden, die von einer Steuerungslogik gesteuert werden, so dass der jeweils verwendete Kode nur die Eigenschaften der Steuerungslogik bestimmt. Nach einer günstigen Realisierungsmöglichkeit für eine solche Steuerungslogik ist beispielsweise ein Festwertspeicher (ROS, ROM) vorgesehen, der auch programmierbar ausgeführt werden kann. Für einen solchen programmierbaren Festwertspeicher (PROM, EAROM, EEROM, etc.) sind bereits zahlreiche Implementierungsformen bekannt geworden. Auch Programmierbare Logische Anordnungen (PLA) kommen in Betracht.

Da erfindungsgemäss die Prüfbiterzeugung byte-seriell erfolgt, ergibt sich gegenüber den vollparallelen Einrichtungen ein gewisser Geschwindigkeitsnachteil, der jedoch für viele Anwendungszwecke, wie z.B. in Druckern oder Bildschirmgeräten, nicht ins Gewicht fällt. Gegenüber einer mit Schieberegistern arbeitenden vollseriellen Einrichtung weist die vorliegende Erfindung noch einen erheblichen Geschwindigkeitsvorteil auf, wobei naturgemäss gegenüber den vollparallelen Einrichtungen, die zumeist aus umfangreichen Exklusiv-Oder-Bäumen bestehen, eine Aufwandsersparnis erzielt wird.

Gerade die Verwendungsmöglichkeit in Anschlussgeräten, wie z.B. den oben erwähnten Druckern oder Bildschirmgeräten, zeigt, dass mit der Erfindung eine Absicherung der zu diesen Geräten übertragenen Daten möglich wird, wie sie bisher nur im Zusammenhang mit Speichern einer Datenverarbeitungsanlage realisiert wurde. Die Entwicklung einer beispielsweise für einen Drukker geeigneten ECC-Einrichtung hat bisher stets zu lange gedauert, so dass in solchen Anschlussgeräten die Sicherung der Datenwörter nur durch einfache Paritätsbits erfolgte. Damit kann jedoch nur ein Einzelfehler erkannt, aber nicht korrigiert werden. Mit der Erfindung ist eine sehr rasche Anpassung der ECC-Einrichtung an den jeweiligen Verwendungszweck möglich geworden, so dass die wenigen Bauteile der erfindungsgemässen Einrichtung, die vom Kode oder der Breite der Übertragungswege abhängen, rasch initialisiert werden können. Eine vollkommen neue Entwicklung eines ECC-Halbleiterchips und die Herstellung dieses Chips für jeweils einen anderen Verwendungszweck ist durch die Erfindung überflüssig geworden.

Ein Ausführungsbeispiel der Erfindung soll nun anhand von Figuren beschrieben werden. Es zeigen:

Fig. 1 den prinzipiellen Aufbau einer mit einem Speicher verbundenen Fehlerkorrektureinrichtung,

Fig. 2 die prinzipielle Schaltungsanordnung eines Ausführungsbeispieles der Erfindung,

Fig. 3 eine Kodematrix,

Fig. 4 eine ausführliche Darstellung der in Fig. 2 gezeigten Schaltungsanordnung,

Fig. 5 Einzelheiten der zeitlichen Steuerung der Anordnung nach Fig. 4, und

Fig. 6 eine Übersicht von Bitauswahlsignalen.

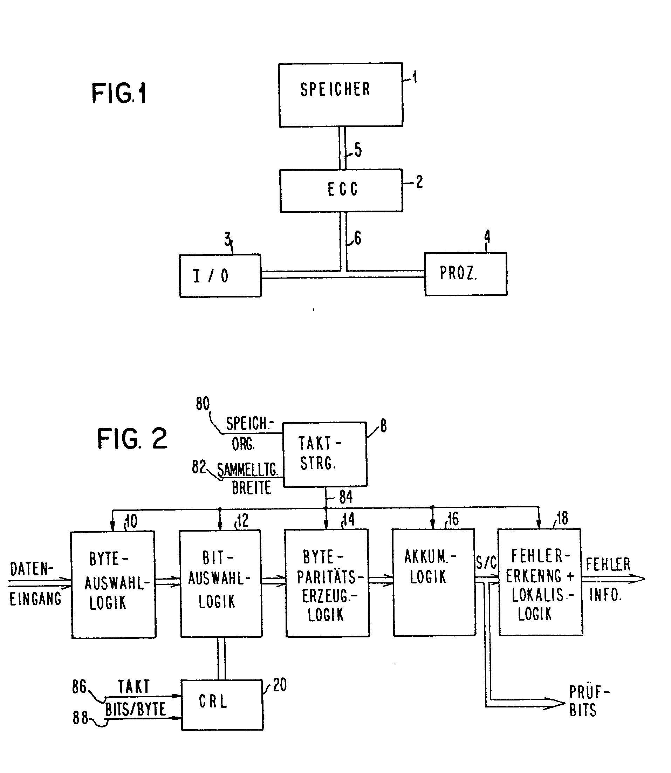

Zunächst soll anhand der Fig. 1 gezeigt werden, wie eine Fehlerkorrektureinrichtung (ECC-Einrichtung) 2 mit einem Speicher 1 zum Einschreiben von Daten und zum Auslesen von Daten verbunden ist. Beim Einschreiben werden zu den von einer Anschlusseinheit 3 oder von einem Prozessor 4 über eine Sammelleitung 6 gelieferten Daten in der Einrichtung 2 Prüfbits erzeugt. Diese Prüfbits werden zusammen mit den betreffenden Daten über die Sammelleitung 5 in den Speicher 1 eingelesen. Beim Auslesen werden von der Einrichtung 2 zu den ausgelesenen Daten nochmals nach der gleichen Vorschrift Prüfbits erzeugt und diese mit den gespeicherten Prüfbits verglichen. Der Vergleich zweier entsprechender Prüfbits ergibt das sogenannte Syndrombit. Sind alle Syndrombits 0, so kann angenommen werden, dass die ausgelesenen Daten mit den vorher eingeschriebenen Daten identisch sind, dass also die Daten nicht auf der Sammelleitung 5 oder im Speicher 1 durch störende Einwirkungen verändert worden waren. Ist eines oder sind mehrere Syndrombits ungleich 0, so kann je nach gewählter Kodierungsvorschrift zur Erzeugung der Prüfbits auf einen Einzelfehler oder einen Doppelfehler geschlossen werden. Meist sind die ECC-Einrichtungen so aufgebaut, dass Einzelfehler korrigiert, Doppelfehler erkannt, aber Fehler noch höherer Ordnung weder erkannt noch korrigiert werden können. Liegt ein Einzelfehler vor, so kann dieser durch Dekodierung des Syndrombitmusters lokalisiert und korrigiert werden. Die korrigierten Daten werden anschliessend über die Sammelleitung 6 an die adressierte Einheit ausgegeben.

Der Aufbau der ECC-Einrichtung hängt von der in einem Datenwort enthaltenen Anzahl Datenbits, d.h. von der Breite Übertragungssammelleitungen 5 und 6 ab, und wird weiterhin davon beeinflusst, ob der Speicher 1 beispielsweise wortorganisiert, halbwortorganisiert oder byteorganisiert ist. Die ECC-Einrichtung 2 kann mit den Einheiten 1, 3 oder 4 baulich vereinigt werden.

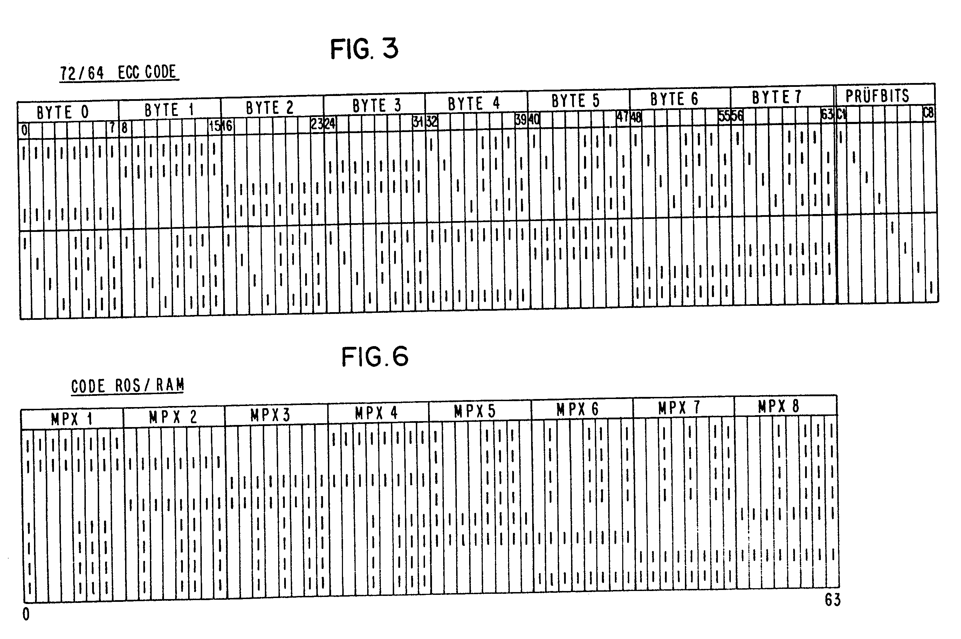

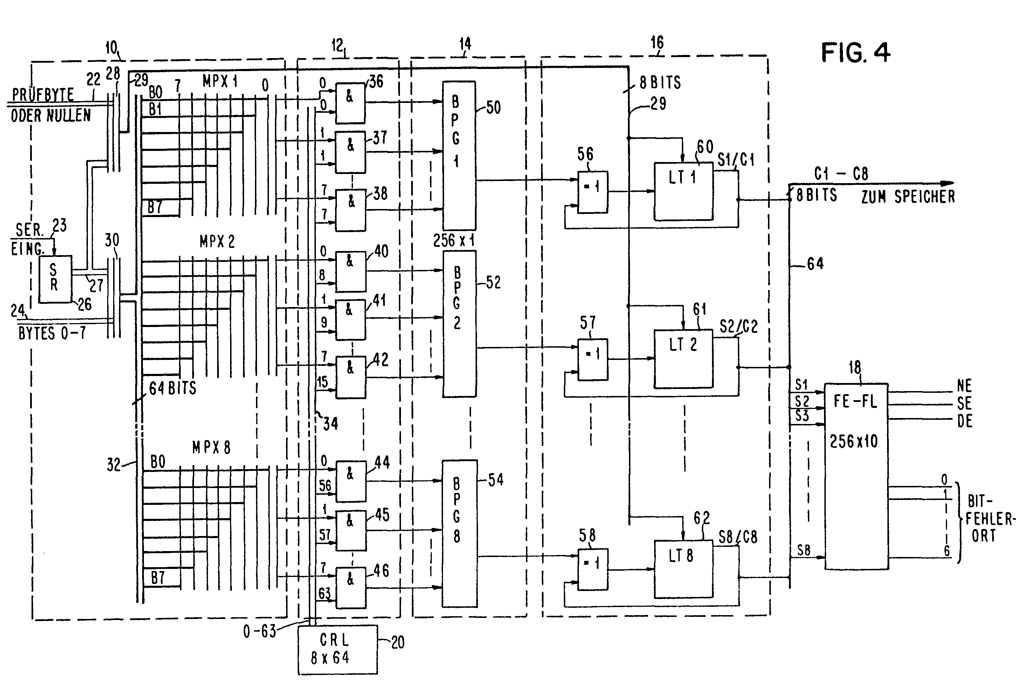

Fig. 2 zeigt eine prinzipielle Schaltungsanordnung eines Ausführungsbeispieles der vorliegenden Erfindung. Die zu kodierenden oder zu überprüfenden Daten werden einer Byteauswahllogik 10 zugeführt. Erfindungsgemäss erfolgt die Erzeugung der Prüfbits byteweise, wie anhand der Fign. 3 und 4 noch näher ausgeführt wird. Zum näheren Verständnis der Erzeugung von Prüfbits wird nun auf Fig. 3 Bezug genommen, die eine Kodematrix, auch «H-Matrix» genannt, zeigt. Im vorliegenden Falle soll das Datenwort acht Datenbytes zu je acht Datenbits aufweisen. Hierzu wird ein Prüfbyte erzeugt, d.h. es werden acht Prüfbits C1–C8 erzeugt. Beispielsweise wird das Prüfbit C1 durch eine Addition modulo 2 aller Datenbits erzeugt, die in der ersten Zeile der Matrix nach Fig. 3 mit einem Strich angegeben sind. Da im vorliegenden Falle die Gesamtanzahl der Bits pro Speicherstelle im Speicher 1 72 beträgt und davon 64 Bits Datenbits D0–D63 sind, wird der vorliegende Kode ein 72/64 Kode genannt. Wie aus Zeile 1 der Matrix ersichtlich ist, werden zur Erzeugung des Prüfbits C1 insgesamt 32 Datenbits verwendet, nämlich die Bits 0–15, 32, 36–38, 40, 44–46, 48, 52–54, 56 und 60–62. Das Prüfbit C1 könnte also durch ein Exklusiv-ODER-Glied mit 32 Eingängen erzeugt werden, oder durch einen modulo 2 Addierer, dem die betreffenden 32 Bits nacheinander zugeführt werden.

Die Erfindung beschreitet hier einen neuen Weg, indem nacheinander zu den einzelnen Datenbytes ein Paritätsbit erzeugt wird und diese Byteparitäten modulo 2 aufakkumuliert werden. Das Akkumulationsresultat entspricht dann einem Paritätsbit über die betreffenden Datenbits aus den acht Datenbytes, also im Falle des obigen Beispiels über dei 32 genannten Datenbits. In Fig. 2 ist hierfür die Byteauswahllogik 10 vorgesehen, welche aus dem eingegebenen Datenwort nacheinander die einzelnen Datenbytes zur Erzeugung des Prüfbits auswählt. Eine nachfolgende Bitauswahllogik 12 wählt entsprechend den in der Matrix nach Fig. 3 angestrichenen Datenbits für jedes Datenbyte diejenigen Datenbits aus, die zur Erzeugung des Prüfbits verwendet werden sollen. Für die restlichen Bits des Bytes werden Nullen weitergeleitet. Die Erzeugung des genannten Byteparitätsbits wird durch die in Fig. 2 gezeigte Byteparitätserzeugungslogik 14 durchgeführt. Die einzelnen Byteparitäten werden in der darauffolgenden Akkumulierungslogik modulo 2 aufsummiert. Am Ausgang der Logik 16 stehen also die Prüfbits C1–C8 zur Verfügung. Werden bei einer Leseoperation zu den ausgelesenen Daten die Prüfbits nochmals erzeugt und mit den ebenfalls ausgelesenen Prüfbits verglichen, so liefert die Akkumulierungslogik 16 auf die weiter unten beschriebene Weise die Syndrombits S1–S8. Eine Fehlererkennungs- und Lokalisierungs-Logik 18 liefert durch Dekodierung der Syndrombits die gewünschte Fehlerinformation. Die in der Logik 18 enthaltene Syndrombit-Dekodierungseinrichtung ist natürlich vom verwendeten Kode abhängig. Da sich dieser Kode jedoch selten ändern, kann für die Logik 18 beispielsweise ein Festwertspeicher vorgesehen werden. In ähnlicher Weise kann die Auswahl der Datenbits, die zur Erzeugung eines Prüfbits verwendet werden müssen, durch eine Koderealisierungslogik 20 erfolgen, für die ebenfalls ein Festwertspeicher verwendet werden kann.

Zur zeitlichen Steuerung der Einrichtung ist eine Taktsteuerung 8 vorgesehen. Diese zeitliche Steuerung hängt jedoch stark davon ab, wieviel Datenbytes in einem Datenwort vorgesehen sind und wie die Speicherorganisation aussieht. Die entsprechenden Steuersignale, die die Speicherorganisation und die Sammelleitungsbreite wiedergeben, müssen der Taktsteuerung 8 also als Steuersignale zugeführt werden. Über eine Leitung 80 wird die Speicherorganisation eingegeben, d.h. die Anzahl Bytes pro Speicherstelle (meist 1, 2, 4 oder 8 Bytes). Damit wird erfasst, für wieviel Bytes pro Speicheroperation Prüfbits erzeugt werden müssen.

Über die Leitung 82 werden Steuersignale eingegeben, welche die Breite der an der ECC-Einrichtung 2 angeschlossenen Sammelleitungen (seriell, oder 1, 2, 4, 8 Bytes) definieren. Vorzugsweise entspricht die Breite der Sammelleitung 5 der Kapazität einer Speicherstelle.

In Ergänzung hierzu werden der Koderealisierungslogik 20 über die Leitungen 86 und 88 Steuersignale zugeführt, welche die von der Anzahl Bytes abhängige Anzahl nötiger Taktsignale und die Anzahl Datenbits pro Datenbyte definieren.

Zur Steuerung der übrigen in Fig. 2 gezeigten funktionellen Einheiten 10–18 ist die Taktsteuerung 8 über eine Steuersammelleitung 84 mit diesen Einheiten verbunden.

Eine ausführliche Darstellung der in Fig. 2 gezeigten prinzipiellen Schaltungsanordnung wird in Fig. 4 gegeben. Auf der linken Seite der Figur sind die verschiedenen Dateneingänge gezeigt. Seriell ankommende Datenbits werden über die Leitung 23 in ein Schieberegister 26 zur Serien-Parallelumsetzung eingelesen. Parallel ankommende Daten werden über die Leitung 24 sowie die Torschaltung 30 auf die Sammelleitung 32 gegeben. Bei einer maximal vorgesehenen Wortlänge von 64 Datenbits hat diese Sammelleitung 32 eine Breite von ebenfalls 64 Bits. Das Schieberegister 26 kann über die Leitung 27 und die Torschaltung 30 ebenfalls mit der Sammelleitung 32 verbunden werden. Bei einer Leseoperation, d.h.

bei einer Operation, bei der ein Datenwort und die dazu gehörenden Prüfbits vom Speicher ausgelesen werden, muss wie oben beschrieben eine Vergleichsoperation mit den neu erzeugten Prüfbits durchgeführt werden. Hierzu ist eine Torschaltung 28 vorgesehen, über die entweder das Prüfbyte im Fall einer Leseoperation oder ein aus lauter Nullen bestehendes Byte im Falle einer Schreiboperation über die Sammelleitung 29 in die Akkumulationslogik eingegeben werden kann. Bei einer seriellen Ausleseoperation erfolgt diese Eingabe über das Schieberegister 26, die Sammelleitung 27 und die Torschaltung 28.

Wie bereits oben beschrieben, werden von der Akkumulierungslogik 16 bei einer Schreiboperation die Prüfbits C1–C8 und bei einer Leseoperation die Syndrombits S1–S8 erzeugt. Die Prüfbits gelangen über die Sammelleitung 64 zum Speicher. Die betreffenden Datenbits, die an der Sammelleitung 24 anliegen, können um die ECC-Einrichtung herum zum Speicher 1 gelangen. Die Sammelleitungen 24 und 64 sind hierzu mit der Sammelleitung 5 (Fig. 1) verbunden.

Bei einer Leseoperation muss das vom Speicher kommende Prüfbyte über die Leitung 22 und die Datenbits entweder über die Leitung 23 oder die Leitung 24 in die ECC-Einrichtung eningegeben werden. Hierzu müssen die genannten Leitungen über geeignete, von einem Lese- oder einem Schreib-Signal gesteuerte Torschaltungen auch mit der Sammelleitung 5 verbunden sein. Zur Realisierung der in Fig. 1 beschriebenen Verbindungsmöglichkeiten sind also geeignete Torschaltungen zwischen den Sammelleitungen 5 bzw. 6 einerseits und den Sammelleitungen 22, 23, 24 und 64 andererseits vorzusehen, welche in geeigneter Weise durch Lese- oder Schreib-Steuersignale gesteuert werden.

Die in Fig. 2 gezeigte Byteauswahllogik 10 besteht aus einer Reihe von Multiplexern MPX1–MPX8. Jeder Multiplexer gibt zu einer ersten Taktzeit das Byte B0, zu einer zweiten Taktzeit das Byte B1 usw. bis Byte B7 an die Bitauswahllogik 12 weiter. In der Logik 12 ist zu jedem Multiplexer eine Reihe von UND-Gliedern vorgesehen. Beispielsweise sind jeweils acht UND-Glieder 36, 37 . . . 38 für den Multiplexer MPX1, UND-Glieder 40, 41 . . . 42 für MPX2 und schliesslich UND-Glieder 44, 45 . . . 46 für MPX8 vorgesehen. Die ersten Eingänge der UND-Glieder sind mit jeweils einem Datenbitausgang der Multiplexer verbunden. Die jeweils zweiten Eingänge dieser UND-Glieder sind über eine Sammelleitung 34 mit der Koderealisierungslogik 20 verbunden. Da es insgesamt 64 UND-Tore 36–46 gibt, ist die Sammelleitung 34 64 Bits breit. Die Koderealisierungslogik 20 ist entsprechend der in Fig. 3 gezeigten Matrix aufgebaut. Zur Zeit der Weitergabe des Byte 0 an die acht Multiplexer MPX1–MPX8 erhalten also die genannten UND-Glieder die folgenden Signale: Die an MPX1 angeschlossenen UND-Glieder 36–38 werden alle entsprechend der ersten Zeile, Feld «Byte 0» der Fig. 3 am zweiten Eingang durchgeschaltet. Von den mit den Multiplexern MPX2 und MPX3 verbundenen UND-Gliedern wird keines entsprechend der zweiten und dritten Zeile im Feld «Byte 0» der in Fig. 3 gezeigen Matrix durchgeschaltet. Hingegen werden entsprechend der vierten Zeile alle UND-Glieder, die mit MPX4 verbunden sind, durchgeschaltet. Von den mit MPX5 verbundenen UND-Gliedern werden die zu den Datenbits D0, D4, D5 und D6 gehörenden UND-Glieder durchgeschaltet. Die Durchschaltung der mit den Multiplexern 6 und 7 verbundenen UND-Glieder ist analog aus Fig. 3, Zeilen 6 und 7 des Feldes «Byte 0», ersichtlich. Schliesslich wird von den mit dem Multiplexer 8 verbundenen UND-Gliedern (44, 45 . . 46) das zu den Datenbits D3, D5, D6 und D7 gehörende UND-Glied durchgeschaltet.

Im nächsten Takt, wenn das Byte 1 des eingegebenen Datenwortes über alle acht Multiplexer durchgeschaltet wird, erfolgt die Durchschaltung der UND-Glieder 36–46 entsprechend der im Feld «Byte 1» angestrichenen Datenbits. Für acht Datenbytes wird die Arbeitsweise der Einrichtung auf die beschriebene Weise fortgesetzt, bis das Byte 7 über die Bitauswahllogik 12 durchgeschaltet ist.

Die von den UND-Gliedern 36–46 weitergegebenen Datenbits gelangen jeweils an einen Byteparitätsgenerator BPG1–BPG8, wofür in Fig. 4 die Bezugszeichen 50, 52 und 54 vorgesehen sind. Jeder BPG besteht beispielsweise aus einem mit den Datenbits adressierten Festwertspeicher mit 256 Eingängen und einem einzigen Ausgang. Da nämlich das binäre Datenbyte, zu dem das Paritätsbit erzeugt werden soll, aus maximal acht Bits besteht, müssen 256 Eingänge vorgesehen werden. Hingegen brauchen die Generatoren 50, 52 und 54 nur ein Bit zu liefern, nämlich das Paritätsbit, so dass nur ein einziger Ausgang vorgesehen werden muss.

Das von jedem Generator BPG1–BPG8 angegebene Paritätsbit gelangt jeweils an eine modulo 2 Addierschaltung in der Akkumulierungslogik 16. Die pro Byteparitätsgenerator vorgesehene modulo 2 Addierschaltung besteht nach Fig. 4 aus einer Kippschaltung LT1–LT8 und einem dazugehörenden Exklusiv-ODER-Glied 56, 57 . . . 58. Dabei ist der Ausgang der Kippschaltung mit dem einen Eingang des Exklusiv-ODER-Gliedes und der andere Eingang dieses Gliedes mit dem Ausgang des entsprechenden Byteparitätsgenerators verbunden. Der Ausgang des Exklusiv-ODER-Gliedes ist mit dem Setzeingang der Kippschaltung LT verbunden. Durch die Akkumulierung der zu den acht Datenbytes erhaltenen Paritätsbits kann nach dem achten Datenbyte am Ausgang jeder Kippschaltung direkt das Prüfbit C1–C8 erhalten werden.

Die bisherige Beschreibung des Ausführungsbeispieles hat bereits gezeigt, dass zur Erzeugung jedes der acht Prüfbits jeweils ein ganz bestimmter Satz von Funktionseinheiten vorgesehen ist. Zur Erzeugung des Prüfbits C1 sind demnach vorgesehen: der Multiplexer MPX1; die Reihe von UND-Gliedern 36, 37, 38; der Byteparitätsgenerator BPG1; das Exklusiv-ODER-Glied 56 und die Kippschaltung 60. Bezug nehmend auf die erste Zeile der in Fig. 3 gezeigten Matrix, die dem Multiplexer MPX1 zugeordnet ist, gelangen also nacheinander die Bytes B0 bis B7 über den Multiplexer MPX1 zur Bitauswahllogik 12. Dabei lassen die in dieser Logik 12 gezeigten UND-Glieder 36 bis 38 nur die Datenbits durch, die in der ersten Zeile der Matrix mit einem strich versehen sind. Die zum Byteparitätsgenerator 50 durchgelassenen binären Signale, deren Wert für die nicht durchgeschalteten UND-Glieder 0 beträgt und die für die gemäss der ersten Zeile der in Fig. 3 gezeigten Matrix durchgeschalteten Datenbits den Wert der durchgeschalteten Datenbits annehmen, werden als Adresse dekodiert, und das an der betreffenden Adresse im Generator 50 stehende Bit wird zur Akkumulierungslogik 16 ausgelesen. Ist das zum Exklusiv-ODER-Glied (beispielsweise 56) ausgelesene Paritätsbit gleich dem in der Kippschaltung (beispielsweise 60) gespeicherten Bits, so liegen am Eingang des Gliedes 56 zwei gleiche binäre Signale an, so dass eine Null in die Kippschaltung 60 gesetzt wird. Sind beide Eingänge zum Glied 56 ungleich, so wird eine Eins in die Kippschaltung 60 gesetzt. Diese Wirkungsweise entspricht einer modulo 2 Addition.

Um einen bei einer Leseoperation nötigen Vergleich zwischen einem neuerzeugten Prüfbit und dem im Speicher 1 gespeicherten Prüfbit durchzuführen, wird das ausgelesene Prüfbit über die Sammelleitung 22, die Torschaltung 28 und die Sammelleitung 29 zu Beginn der Prüfbiterzeugung in die Kippschaltung gesetzt. Dadurch bleibt letzten Endes in der Kippschaltung eine Null stehen, wenn das neu erzeugte Prüfbit C' gleich dem ausgelesenen Prüfbit C ist. Anderenfalls bleibt eine Eins in der Kippschaltung bestehen. Die nach Ablauf der erneuten Prüfbiterzeugung, also nach durchgeführtem Vergleich in den Kippschaltungen stehenden Bits, die wie eingangs ausgeführt «Syndrombits» genannt werden (S1–S8), werden über die Sammelleitung 64 in eine Fehlererkennungs-Fehlerlokalisator-Logik 18 eingelesen. Auch diese Logik 18 kann als Festwertspeicher ausgeführt werden, wobei die acht Syndrombits 256 Adressen ergeben und an jeder Adresse beispielsweise zehn Bits gespeichert sind. Diese Bits haben folgende Bedeutung:

NE: Alle Syndrombits sind Null, es liegt kein Fehler vor.

SE: Es wurde ein Einzelfehler dekodiert. Nach dem in Fig. 3 gezeigten Kode liegt der Einzelfehler in einem Prüfbit, wenn ein einziges Syndrombit den Wert Eins hat und liegt ein Einzelfehler unter den Datenbits vor, wenn drei oder fünf Syndrombits den Wert Eins haben. Je nachdem, welche Syndrombits den Wert Eins haben, kann durch Dekodierung in der Logik 18 der Ort des Einzelfehlers lokalisiert werden.

DE: Es liegt ein Doppelfehler vor, der bei Verwendung des Kodes nach Fig. 3 wohl erkannt aber nicht korrigiert werden kann. Bei einem Doppelfehler hat eine gerade Anzahl (2, 4 oder 6) von Syndrombits den Wert Eins.

Die von der Logik 18 ausgelesenen restlichen sieben Bits geben für das einzige fehlerhafte Bit aus insgesamt 72 Bits den Fehlerort an.

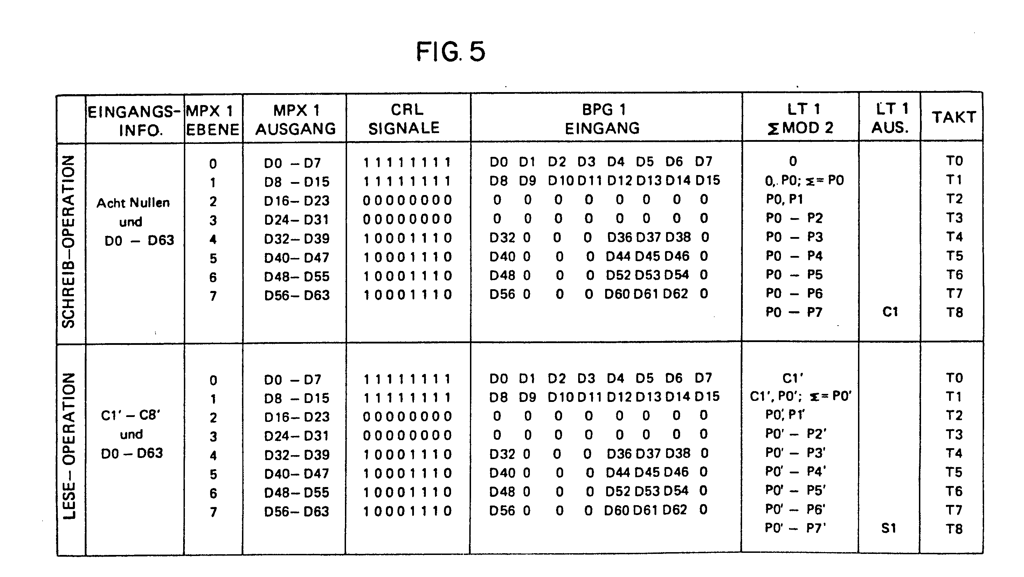

Der zeitliche Ablauf bei der Erzeugung der Prüf- und Syndrombits soll nun anhand der Fign. 5 und 6 näher erläutert werden. Fig. 5 bezieht sich insbesondere auf die Erzeugung des ersten Prüf- oder Syndrombits, C1 und S1, d.h. auf die erste Zeile in der Matrix nach Fig. 3.

Zur Erzeugung des Prüfbits C1 werden an den Eingang der ECC-Einrichtung die 64 Datenbits D0–D63 sowie zum ursprünglichen Setzen der Kippschaltungen LT1–LT8 ein Nullbyte (8 Nullbits) angelegt oder die Kippschaltungen zurückgestellt. Während des Taktes T0 wird die Nullte Ebene des Multiplexers MPX1 durchgeschaltet und am Ausgang des Multiplexers sind somit die Datenbits D0–D7 erhältlich. Die von der Koderealisierungslogik 20 an die UND-Glieder 36–38 gelieferten Signale bestehen gemäss der ersten Zeile in Fig. 5 aus lauter Einsen. Dementsprechend werden an den Eingang des Paritätsgenerators BPG1 alle acht Datenbits D0–D7 angelegt, wobei natürlich der Wert jedes einzelnen Datenbits Null oder Eins sein kann. Am Ausgang des Generators 50 ist sodann das Paritätsbit P0 erhältlich, während zu diesem Zeitpunkt in der Kippschaltung LT1 noch eine Null gespeichert ist.

In der nächsten Zeile, in Fig. 5 sind die Vorgänge zur Taktzeit T1 dargestellt. Es wird die erste Ebene des Multiplexers durchgeschaltet und das zweite Datenbyte B1 mit den Bits D8–D15 zu der Reihe von UND-Gliedern 36–38 weitergegeben. Entsprechend der ersten Zeile in Fig. 3 werden wiederum alle diese UND-Glieder durchgeschaltet und somit alle acht Datenbits D6–D15 an den Eingang des Generators 50 angelegt. Am Ausgang des Generators wird zu diesem Zeitpunkt das Paritätsbit P1 erhalten, während inzwischen zu der ursprünglichen Null in der Kippschaltung 60 das Paritätsbit P0 addiert wurde, so dass nunmehr der Inhalt von LT1 gleich dem Paritätsbit P0 ist.

Während der folgenden Taktperioden T2 bis T7 wird jeweils eine weitere Ebene des Multiplexers MPX1 durchgeschaltet und damit ein weiteres Datenbyte weitergeleitet. Die gemäss der ersten Zeile der Matrix in Fig. 3 von der Koderealisierungslogik 20 erzeugten CRL-Durchschaltesignale für die UND-Glieder 36 bis 38 sowie die entsprechend an den Eingang des Generators 50 weitergeleiteten Datenbits sind in den beiden entsprechenden Feldern der Fig. 5 aufgeführt. Aus der nächsten Spalte «LT1» der Fig. 5 ist ersichtlich, aus welchen modulo 2 addierten Paritätssignalen sich der jeweilige Inhalt der Kippschaltung LT1 ergibt. Im letzten Takt T8 wird dann das im vorigen Takt T7 erzeugte Paritätsbit P7 noch zum Inhalt der Kippschaltung 60 addiert, so dass nach Ablauf des Taktes T8 in dieser Kippschaltung das Prüfbit C1 steht.

Bei einer Leseoperation läuft der geschilderte Vorgang ebenso ab, nur dass nunmehr vor Beginn der Paritätsbit-Akkumulierung in die jeweilige Kippschaltung das aus dem Speicher ausgelesene Prüfbit C1' gesetzt wird. Hierzu wird das ausgelesene Prüfbyte über die Sammelleitung 22, die Torschaltung 28 und die Sammelleitung 29 in die Kippschaltungen LT1–LT8 vor Beginn der Prüfbiterzeugung eingelesen. Nach Ablauf des Taktes T8 steht also in der Kippschaltung das Syndrombit S1.

Fig. 6 zeigt nochmals in übersichtlicher Weise die von der Koderalisierungslogik 20 erzeugten Bitauswahlsignale. Die in Fig. 6 gezeigten acht Zeilen entsprechen den acht Taktperioden T0–T7. Eine Zeile der Fig. 6 zeigt also die während der betreffenden Taktperiode von der Koderealisierungslogik 20 gelieferten binären Signale zur Durchschaltung der UND-Glieder der Bitauswahllogik 12. Da im gezeigten Beispiel acht Datenbytes durchgeschaltet werden müssen, muss auch die Logik 20 8 × 64 Steuerbits zur Durchschaltung der UND-Glieder erzeugen. Es ist ein wesentliches Merkmal der vorliegenden Erfindung, dass sich der jeweils verwendete Kode nur auf die Koderealisierungslogik 20 und auf die Fehlererkennungs- und Fehlerlokalisierungslogik 18 auswirkt. Die Logikeinrichtungen 18 und 20 können in vorteilhafter Weise als Festwertspeicher ausgeführt werden (ROS, ROM, EAPROM, EAROM, PLA, etc.), wobei diese Einrichtungen vor der Inbetriebnahme der ECC-Einrichtung initialisiert werden. Alle übrigen in Fig. 4 gezeigten Einrichtungen hängen vom jeweils verwendeten Kode nicht ab, so dass sich die in Fig. 4 gezeigte Einrichtung leicht in Serienfabrikation und wie noch ausgeführt wird auf einem einzigen Halbleiterchip herstellen lässt.

Wird nicht die maximal mögliche Wortbreite von acht Datenbytes benötigt (Leitungen 80, 82, Fig. 2), so wird die Taktanzahl entsprechend vermindert (Leitungen 86, Fig. 2). Es werden dann also nicht alle Ebenen der Multiplexer, nicht alle UND-Glieder der Bitauswahllogik und nicht alle Sätze von Funktonseinheiten gemäss Fig. 4 verwendet, da bei geringerer Anzahl von Datenbits (Leitungen 88, Fig. 2) auch die Anzahl der Prüfbits kleiner gehalten werden kann. Beispielsweise finden folgende Werte praktische Verwendung:

1 Datenbyte: 5 Prüfbits;
2 Bytes: 6 Prüfbits;
4 Bytes: 7 oder 8 Prüfbits;
8 Bytes: 8 Prüfbits.

Die im Ausführungsbeispiel der vorliegenden Erfindung dargestellte Einrichtung ist also bis zu maximal 64 Datenbits und acht zusätzlichen Prüfbits verwendbar, wobei die Einrichtung auch für jede geringere Anzahl von Daten- oder Prüfbits durch entsprechende Reduzierung der Taktperioden und entsprechenden Nichtverwendung von in Fig. 4 gezeigten Logikgliedern und nicht benötigten Sätzen von Funktionseinheiten verwendet werden kann. Die erfindungsgemässe Einrichtung garantiert also eine maximale universelle Verwendbarkeit bei weitgehend standardisiertem Aufbau der einzelnen Funktionseinheiten.

Die für ein Halbleiterchip mit der erfindungsgemässen ECC-Einrichtung benötigten Anschlüsse (Pins) betragen beispielsweise 101:

10 Steueranschlüsse für die Taktsteuerung 8 (Fig. 2) und die Koderealisierungslogik 20 (Fig. 2),

72 Dateneingangsanschlüsse (Sammelleitungen 22 und 24),

1 serieller Dateneingang 23,

8 Prüfbitausgänge (Sammelleitung 64), 10 Ausgänge der Fehlererkennungs- und Fehlerlokalisierungslogik 18.

Die genannte Anzahl von 101 Chipanschlüssen ist technologisch realisierbar.

Bei den derzeit realisierbaren Integrationsdichten stellt auch die Unterbringung der in Fig. 2 gezeigten Einrichtung auf einem einzigen Halbleiterchip kein technologisches Problem dar. Die Unterbringung auf einem einzigen Chip wird letztlich durch die erfindungsgemässe byteweise Erzeugung der Prüfbits und Syndrombits ermöglicht. Diese Arbeitsweise erlaubt für viele Anwendungen einen besonders günstigen Kompromiss zwischen voll serieller Arbeitsweise, die zwar wenig Schaltungen benötigt, jedoch langsam ist, und voll paralleler Arbeitsweise, die einen grossen Schaltungsaufwand bedingt.

## Patentansprüche

1. Modulare Einrichtung zur Einzelfehler-Korrektur und Doppelfehler-Erkennung in einem durch Prüfbits gesicherten und in mehrere Datenbytes unterteilten Datenwort, mit einer Anordnung zur Erzeugung von Prüfbits entsprechend der Kodematrix des gewählten Prüfkodes und mit einer Anordnung zur Angabe von Fehlerart und Fehlerort (ECC-Einrichtung), dadurch gekennzeichnet, dass für jedes zu erzeugende Prüfbit (z.B. C1) die folgenden, für jedes Prüfbit gleiche Einrichtungen vorgesehen sind:

– ein Multiplexer (10; MPX1) zur aufeinanderfolgenden Durchschaltung der einzelnen Datenbytes (B0–B7) des Datenwortes an eine Bitauswahllogik (12),

– eine Torschaltung (36–38) in der Bitauswahllogik zur Auswahl der entsprechend dem Prüfkode benötigten Datenbits des gerade durchgeschalteten Bytes,

– ein Byteparitätsgenerator (50) zur Erzeugung eines Paritätsbits zu den ausgewählten Datenbits, und

– eine Addierschaltung (56, 60) zur Aufsummierung modulo 2 der Paritätsbits,

und dass ferner eine Koderealisierungslogik (20) vorgesehen ist, die jeweils für das durchgeschaltete Datenbyte die zu den einzelnen Prüfbits (C1–C8) gehörenden Torschaltungen (36–46) entsprechend dem verwendeten Prüfkode steuert.

2. Einrichtung nach Anspruch 1, dadurch gekennzeichnet, dass die Koderealisierungs-Logik (20) als Festwertspeicher ausgeführt und über eine Sammelleitung (34) mit den zu den einzelnen Prüfbits (C1–C8) gehörenden Torschaltungen (36–46) verbunden ist.

3. Einrichtung nach Anspruch 1, dadurch gekennzeichnet, dass die Torschaltung pro Prüfbit eine Reihe von UND-Gliedern (36–38) aufweist.

4. Einrichtung nach Anspruch 1, dadurch gekennzeichnet, dass eine Taktsteuerung (8) Steuersignale (80, 82, Fig. 2) zur Definition der Datenwortbreite empfängt und eine der Anzahl Bytes eines Datenwortes entsprechende Anzahl Taktpulse (T0–T7, Fig. 5) zur Steuerung jedes Multiplexers (MPX1–MPX8) abgibt, so dass nur die Byte-Eingänge (0–7) der Multiplexer durchgeschaltet werden, an denen Datenbytes anliegen.

5. Einrichtung nach den Ansprüchen 3 und 4, dadurch gekennzeichnet, dass die Koderealisierungs-Logik (20) Steuersignale (86, 88, Fig. 2) zur Definition der Anzahl Bits pro Datenbyte empfängt und eine dieser Bitanzahl entsprechende Anzahl Torsteuersignale pro Takt an die UND-Glieder (36–38) abgibt, so dass nur die UND-Glieder einer Reihe durchgeschaltet werden, an denen Datenbits anliegen.

6. Einrichtung nach Anspruch 1, dadurch gekennzeichnet, dass die zu den einzelnen Prüfbits (C1–C8) gehörenden Addierschaltungen jeweils eine über ein Exklusiv-ODER-Glied (56–58) rückgekoppelte Kippschaltung (LT1–LT8) aufweisen und dass die Setzeingänge aller Kippschaltungen mit einer gemeinsamen Sammelleitung (29) verbunden sind.

7. Einrichtung nach Anspruch 6, wobei bei einer Schreiboperation des Datenwortes in einen Speicher (1) zum Datenwort Prüfbits erzeugt und zusammen mit dem Datenwort im Speicher abgespeichert werden, und bei einem Lesevorgang das Datenwort zusammen mit den gespeicherten Prüfbits ausgelesen wird und zum ausgelesenen Datenwort neue Prüfbits erzeugt und mit den zuvor abgespeicherten Prüfbits verglichen werden, und dass bei einer Schreibpoperation über die gemeinsame Sammelleitung (29) eine Null in alle Kippschaltungen (LT1–LT8) gesetzt wird, oder alle Kippschaltungen zurückgestellt werden, und dass bei einer Leseoperation über die Sammelleitung (29) die gespeicherten Prüfbits in die entsprechenden Kippschaltungen gesetzt werden (z.B. C1 in LT1), derart, dass nach der erneuten Erzeugung der Prüfbits in den Kippschaltungen Fehlersyndrombits (S1–S8) gespeichert sind.

8. Einrichtung nach Anspruch 7, dadurch gekennzeichnet, dass die Ausgänge aller Kippschaltungen (LT1–LT8) über eine weitere gemeinsame Sammelleitung (64) mit einer Fehlererkennungs- und Fehlerlokalisator-Logik (18) verbunden sind, und dass diese Logik (18) als Festwertspeicher ausgeführt ist.

9. Einrichtung nach den Ansprüchen 2 und 8, dadurch gekennzeichnet, dass die Koderealisierungs-Logik (20) und die Fehlererkennungs- und Fehlerlokalisator-Logik (18) als personalisierbare Halbleiterspeicher ausgeführt sind.

10. Einrichtung nach Anspruch 7, dadurch gekennzeichnet, dass die ECC-Einrichtung (2) mit den folgenden Eingängen und Ausgängen versehen ist:

– ein mit einer Speichersammelleitung (5) verbundener Sammelleitungs-Eingang (22) zum Zuführen des im Speicher gespeicherten Prüfbytes,

– eine serielle Eingangsleitung (23) zur Zuführung von seriell übertragenen Datenbits, wobei dieser Eingang (23) mit einem Serien-Parallelumsetzer (26) verbunden ist, und der Ausgang (27) dieses Umsetzers sowie der Sammelleitungseingang (22) über eine Torschaltung (28) mit der zu den Kippschaltungen (60–62) führenden gemeinsamen Sammelleitung (29) verbindbar sind,
– eine zweite Sammelleitung (24) zur parallelen Zuführung der Bytes (B0–B7) des Datenwortes, wobei der Ausgang (27) des Umsetzers (26) und die zuletzt genannte Sammelleitung (24) über eine Torschaltung (30) mit einer mit den Eingängen aller Multiplexer (MPX1–MPX8) verbundenen dritten Sammelleitung (32) verbunden ist,
wobei die serielle Eingangsleitung (23) und die zweite Sammelleitung (24) sowohl mit der von der ECC-Einrichtung (2) zum Speicher führenden Speichersammelleitung (5), als auch mit einer zu Eingangs-, Ausgangsgeräten (3), oder zu einem Prozessor (4) führenden vierten Sammelleitung (6) verbindbar sind.

**Claims**

1. Modular device for single error correction and double error detection in a data word protected by check bits and subdivided into several data bytes, with an arrangement for generating check bits in accordance with the code matrix of the check code used, and with an arrangement indicating type and location of the error (ECC device), characterized in that for each bit (e.g. C1) to be generated the following devices which are the same for each check bit are provided:
– a multiplexer (10; MPX1) for the successive passing-on of the individual data bytes (B0–B7) of the data word to a bit selection logic (12),
– a gating circuit (36–38) in the bit selection logic for selecting the data bits required in accordance with the check code, of the byte just passed on,
– a byte parity generator (50) to generate a parity to the data bits selected, and
– and adder (56, 60) for the modulo 2 summing up of the parity bits,
and in that furthermore a code implementing logic (20) is provided which for the respective switched data byte controls the gates (36–46) belonging to the individual check bits (C1–C8), in accordance with the check code applied.

2. Device as claimed in claim 1, characterized in that the code implementing logic (20) is designed as a read-only storage, and connected via a bus (34) to the gating circuits (36–46) belonging to the individual check bits (C1–C8).

3. Device as claimed in claim 1, characterized in that the gating circuit per check bit comprises a series of AND gates (36–38).

4. Device as claimed in claim 1, characterized in that a clock control (8) receives control signals (80, 82 Fig. 2) for defining the data word width, and that it supplies a number of clock pulses (T0–T7, Fig. 5) corresponding to the number of bytes of a data word controlling each multiplexor (MPX1–MPX8), so that only those byte input (0–7) of the multiplexors are switched through to which data bytes are applied.

5. Device as claimed in claims 3 and 4, characterized in that the code implementing logic (20) receives control signals (86, 88, Fig. 2) for defining the number of bits per data byte, and that it emits to the AND gates (36–38) a number of gate control signals per clock period corresponding to this bit number, so that only those AND gates of a series are enabled to which data bits are applied.

6. Device as claimed in claim 1, charaterized in that the adders belonging to the individual check bits (C1–C8) each comprise a flipflop (LT1–LT8) fed back via an Exclusive-OR gate (56–58), and the set imputs of all flipflops are connected to a common bus (29).

7. Device as claimed in claim 6, wherein during the write operation of the data word in a storage (1) clock check bits are generated to the data word, and stored together with the data word, and wherein during a read operation the data word is read out together with the stored check bits, and new check, bits are generated to the read-out data word, and compared with the previously stored check bits, and that during a write operation a Zero is set via the common bus (29) in all flipflops (LT1–LT8), or all flipflops are reset, and that in a read operation the stored check bits are set via the bus (29) in the corresponding flipflops (e.g. C1 in LT1), in such manner that after the renewed generation of the check bits error syndrome bits (S1–S8) are contained in the flipflop.

8. Device as claimed in claim 7, characterized in that the outputs of all flipflops (LT1–LT8) are connected via another common bus (64) to an error detecting and localizing logic (18) and that this logic (18) is designed as a read-only storage.

9. Device as claimed in claims 2 and 8, characterized in that the code implementing logic (20) and the error detecting and localizing logic (18) are designed as personalizable semiconductor storages.

10. Device as claimed in claim 7, characterized in that the ECC device (2) comprises the following inputs and outputs:
– a bus input (22) connected with a storage bus (5), for applying the check byte stored in the storage,
– a serial input line (23) for applying serially transferred data bits, this input (23) being connected to a series-parallel converter (26), and the output (27) of this converter as well as the bus input (22) being connectable via a gate (28) to the common bus (29) for the flipflops (60–62),
– a second bus (24) for the parallel application of the bytes (B0–B7) of the data word, the output (27) of the converter (26), and the last-mentioned bus (24) being connected via a gating circuit (30) to a third bus (32) connected to the inputs of all multiplexors (MPX1–MPX8),
the serial input line (23) and the second bus (24) being connectable to the storage bus (5) from the ECC device (2) to the storage, as well as to a fourth bus (6) to input and output devices (3), or to a processor (4).

**Revendications**

1. Dispositif modulaire pour la correction d'erreurs simples et la reconnaissance d'erreurs doubles dans un mot de données protégé par des bits de contrôle et subdivisé en plusieurs octets de données, comportant un dispositif pour produire des bits de contrôle conformément à la matrice du code de contrôle choisi et un dispositif pour indiquer le type d'erreur et l'emplacement de l'erreur (dispositif ECC), caractérisé en ce que pour chacun des bits de contrôle devant être produits (par exemple C1), il est prévu les dispositifs suivants, qui sont les mêmes pour chaque bit de contrôle:

– un multiplexeur (10; MPX1) pour la transmission successive des différents octets de données (B0–B7) du mot de données à une logique (12) de sélection des bits,

– un circuit de porte (36–38) situé dans la logique de sélection de bits pour réaliser la sélection des bits de données, nécessaires conformément au code de contrôle, de l'octet précisément transmis,

– un générateur (50) de parité d'octet pour produire un bit de parité pour les bits de données sélectionnés, et

– un circuit additionneur (56, 60) pour réaliser l'addition modulo 2 des bits de parité,
et qu'en outre il est prévu une logique (20) de réalisation de code, qui, respectivement pour l'octet de données transmis, commande les circuits de porte (36–46), associés aux différents bits de contrôle (C1–C8), conformément au code de contrôle utilisé.

2. Dispositif selon la revendication 1, caractérisé en ce que la logique (20) de réalisation de code est réalisée sous la forme d'une mémoire morte et est reliée par l'intermédiaire d'un ligne formant bus (34) aux circuits de porte (36–46) associés aux différents bits de contrôle (C1–C8).

3. Dispositif selon la revendication 1, caractérisé en ce que le circuit de porte comporte, pour chaque bit de contrôle, une série de circuits (36–38).

4. Dispositif selon la revendication 1, caractérisé en ce qu'un dispositif (8) de commande cadencée reçoit des signaux de commande (82, figure 2) pour la définition de la largeur des mots de données et délivre un nombre, correspondant au nombre des octets d'un mot de données, d'impulsions de cadence (T0–T7, figure 5) pour commander chaque multiplexeur (MPX1–MPX8) de telle sorte que seules les entrées d'octets (0–7) des multiplexeurs, auxquelles les octets de données sont appliqués, sont placées à l'état passant.

5. Dispositif selon les revendications 3 et 4, caractérisé en ce que la logique (20) de réalisation de code reçoit des signaux de commande (86, 88, figure 2) pour définir le nombre des bits par octet de données et délivre un nombre, correspondant à ce nombre de bits, de signaux de commande de portes pour chaque impulsion de cadence au circuit ET (36–38) de sorte que les circuits ET d'une rangée, auxquels des bits de données sont appliqués, sont placés à l'état passant.

6. Dispositif selon la revendication 1, caractérisé en ce que des circuits additionneurs, qui sont associés aux différents bits de contrôle (C1–C8), comportent chacun un circuit à bascule bistable (LT1–LT8) couplé par réaction au moyen d'un circuit OU-Exclusif (56–58) et que les entrées de positionnement de tous les circuits à bascule bistable sont reliées à une ligne commune formant bus (29).

7. Dispositif selon la revendication 6, dans lequel, lors d'une opération d'enregistrement d'un mot de données dans une mémoire (1), des bits de contrôle sont produits pour le mot de données et sont mémorisés, ainsi que le mot de données, dans la mémoire et dans lequel, lors d'un processus de lecture, le mot de données est lu ainsi que les bits de contrôle mémorisés et de nouveau bits de contrôle sont produits pour le mot de données lu et sont comparés aux bits de contrôle mémorisés antérieurement, et dans lequel, lors d'une opération d'enregistrement un zéro est positionné dans tous les circuits à bascule bistable (LT1–LT8) ou bien tous les circuits à bascule bistable sont ramenés à l'état initial, par l'intermédiaire d'une ligne commune formant bus (29), et dans lequel, lors d'une opération de lecture, les bits de contrôle mémorisés sont positionnés dans les circuits à bascule bistable correspondants (par exemple C1 dans LT1), par l'intermédiaire de la ligne formant bus (29) de telle sorte qu'après la nouvelle production des bits de contrôle, des bits de syndrome d'erreur (S1–S8) sont mémorisés dans les circuits à bascule bistable.

8. Dispositif selon la revendication 7, caractérisé en ce que les sorties de tous les circuits à bascule bistable (LT1–LT8) sont reliées par l'intermédiaire d'une autre ligne commune formant bus (64) à une logique (18) de reconnaissance et de localisation d'erreurs et que cette logique (18) est réalisée sous la forme d'une mémoire morte.

9. Dispositif selon les revendications 2 et 8, caractérisé en ce que la logique (20) de réalisation de code et la logique (18) de reconnaissance et de localisation d'erreurs sont réalisées sous la forme de mémoires à semiconducteurs pouvant être personnalisées.

10. Dispositif selon la revendication 7, caractérisé en ce que le dispositif ECC (2) comporte les entrées et sorties suivantes:

– une entrée (22) de ligne formant bus, qui est reliée à une ligne formant bus (5) de la mémoire et sert à envoyer l'octet de contrôle mémorisé dans la mémoire,

– une ligne d'entrée série (23) servant à délivrer des bits de données transmis en série, cette entrée (23) étant reliée à un convertisseur série/parallèle (26), tandis que la sortie (27) de ce convertisseur et l'entrée de la ligne formant bus peuvent être reliées par l'intermédiaire d'un circuit de porte (28) à la ligne commune formant bus (29) aboutissant aux circuits à bascule bistable (60–62),

– une seconde ligne formant bus (24) pour la délivrance en parallèle des octets (B0–B7) du mot de données, la sortie (27) du convertisseur (26) et la ligne formant bus (24) indiquée en dernier lieu étant reliées par l'intermédiaire d'un circuit de porte (30) à une troisième ligne formant bus (32) reliée aux entrées de tous les multiplexeurs (MPX1–MPX8), la ligne d'entrée série (23) et la seconde ligne formant bus (24) pouvant être reliées aussi bien à la ligne formant bus (5) de la mémoire, qui relie le dispositif ECC (2) de la mémoire, qu'à une quatrième ligne formant bus (6) aboutissant à l'un des appareils d'entrée, à l'un des appareils de sortie (3) ou à un processeur (4).

**FIG.1**

SPEICHER — 1

— 5

ECC — 2

— 6

3
I / 0

4
PROZ.

**FIG. 2**

80 SPEICH.-ORG.

TAKT-STRG. — 8

82 SAMMELLTG. BREITE

— 84

DATEN-EINGANG → BYTE-AUSWAHL-LOGIK (10) → BIT-AUSWAHL-LOGIK (12) → BYTE-PARITÄTS-ERZEUG.-LOGIK (14) → AKKUM.-LOGIK (16) → S/C → FEHLER-ERKENNG + LOKALIS.-LOGIK (18) → FEHLER INFO.

86 TAKT

88 BITS/BYTE

CRL — 20

PRÜF-BITS

FIG. 3

72/64 ECC CODE

| BYTE 0 | BYTE 1 | BYTE 2 | BYTE 3 | BYTE 4 | BYTE 5 | BYTE 6 | BYTE 7 | PRÜFBITS |

FIG. 6

CODE ROS/RAM

| MPX 1 | MPX 2 | MPX 3 | MPX 4 | MPX 5 | MPX 6 | MPX 7 | MPX 8 |

FIG. 4

# FIG. 5

| | EINGANGS-INFO. | MPX 1 EBENE | MPX 1 AUSGANG | CRL SIGNALE | BPG 1 EINGANG | | | | | | | | LT 1 Σ MOD 2 | LT 1 AUS. | TAKT |
|---|---|---|---|---|---|---|---|---|---|---|---|---|---|---|---|
| SCHREIB-OPERATION | Acht Nullen und D0 — D63 | 0 | D0 — D7 | 11111111 | D0 | D1 | D2 | D3 | D4 | D5 | D6 | D7 | 0 | | T0 |
| | | 1 | D8 — D15 | 11111111 | D8 | D9 | D10 | D11 | D12 | D13 | D14 | D15 | 0,. P0; Σ = P0 | | T1 |
| | | 2 | D16— D23 | 00000000 | 0 | 0 | 0 | 0 | 0 | 0 | 0 | 0 | P0, P1 | | T2 |
| | | 3 | D24— D31 | 00000000 | 0 | 0 | 0 | 0 | 0 | 0 | 0 | 0 | P0 — P2 | | T3 |
| | | 4 | D32— D39 | 10001110 | D32 | 0 | 0 | 0 | D36 | D37 | D38 | 0 | P0 — P3 | | T4 |
| | | 5 | D40— D47 | 10001110 | D40 | 0 | 0 | 0 | D44 | D45 | D46 | 0 | P0 — P4 | | T5 |
| | | 6 | D48— D55 | 10001110 | D48 | 0 | 0 | 0 | D52 | D53 | D54 | 0 | P0 — P5 | | T6 |
| | | 7 | D56— D63 | 10001110 | D56 | 0 | 0 | 0 | D60 | D61 | D62 | 0 | P0 — P6 | | T7 |
| | | | | | | | | | | | | | P0 — P7 | C1 | T8 |
| LESE— OPERATION | C1' — C8' und D0 — D63 | 0 | D0 — D7 | 11111111 | D0 | D1 | D2 | D3 | D4 | D5 | D6 | D7 | C1' | | T0 |
| | | 1 | D8 — D15 | 11111111 | D8 | D9 | D10 | D11 | D12 | D13 | D14 | D15 | C1', P0'; Σ = P0' | | T1 |
| | | 2 | D16— D23 | 00000000 | 0 | 0 | 0 | 0 | 0 | 0 | 0 | 0 | P0', P1' | | T2 |
| | | 3 | D24— D31 | 00000000 | 0 | 0 | 0 | 0 | 0 | 0 | 0 | 0 | P0' — P2' | | T3 |
| | | 4 | D32— D39 | 10001110 | D32 | 0 | 0 | 0 | D36 | D37 | D38 | 0 | P0' — P3' | | T4 |
| | | 5 | D40— D47 | 10001110 | D40 | 0 | 0 | 0 | D44 | D45 | D46 | 0 | P0' — P4' | | T5 |
| | | 6 | D48— D55 | 10001110 | D48 | 0 | 0 | 0 | D52 | D53 | D54 | 0 | P0' — P5' | | T6 |
| | | 7 | D56— D63 | 10001110 | D56 | 0 | 0 | 0 | D60 | D61 | D62 | 0 | P0' — P6' | | T7 |
| | | | | | | | | | | | | | P0' — P7' | S1 | T8 |

0 067 301